# EUROPEAN PATENT APPLICATION

(11) **EP 3 385 067 A2**
(43) Date of publication of application: **10.10.2018**
(21) Application number: 18164972.4
(22) Date of filing: 29.03.2018
(51) Int. Cl.: B29D 11/00, B05D 1/32

(54) **METHOD FOR PRODUCING OPTICAL COMPONENT HAVING A PROCESSED PATTERN**

(30) Priority: 07.04.2017 JP 2017077067
(71) Applicant: Hoya Lens Thailand Ltd., Pathumthani 12130 (TH)
(72) Inventor: KIKUCHI, Naoki, Tokyo, 160-8347 (JP); YAMANOUCHI, Kazuhito, Tokyo, 160-8347 (JP)
(74) Representative: Hoffmann Eitle

(57) **Abstract**

A method for producing an optical component (1) having a processed pattern (15b) formed thereon and includes: a resist pattern forming step (S2) of forming a resist pattern (21) containing a water-soluble polymer (21) on a lens substrate (11); a water-insoluble layer forming step (S3) of forming a water-insoluble layer (15) on the lens substrate (11) on which the resist pattern (21) is formed; and a removing step (S4) of removing the water-insoluble layer (15) formed on the resist pattern (21) by removing the resist pattern (21) with an water-based solvent to form a processed pattern (15b).

## Description

### BACKGROUND

### Technical Field

The present disclosure relates to a method for producing an optical component having a processed pattern formed thereon.

### Related Art

A spectacle lens has various layers that coat the surface of a lens substrate. Examples of the various layers include a hard coat layer for preventing the lens substrate from being scratched, an antireflection layer for preventing light from being reflected by a lens surface, and a water-repellent layer for preventing water spotting on the lens. In addition, recently, a coating method for forming a predetermined pattern on an optical component has been proposed (for example, JP 2008-55253 A).

### SUMMARY

According to the method for forming a processed pattern of JP 2008-55253 A, an organic solvent is used when a printed pattern that becomes a resist pattern is removed (peeled off) . Due to use of the organic solvent, a problem arises in that a special treatment needs to be performed in a water discharge treatment or options of the type of hard coat layer materials are limited depending on compatibility of the organic solvent with the hard coat layer materials.

In this regard, the present disclosure is intended to provide a method for producing an optical component, the method capable of forming a processed pattern on the optical component by using an water-based solvent in a removing step.

A method for producing an optical component having a processed pattern formed thereon according to an embodiment of the present disclosure includes:
a resist pattern forming step of forming a resist pattern containing a water-soluble polymer on a lens substrate;
a water-insoluble layer forming step of forming a water-insoluble layer on the lens substrate on which the resist pattern is formed; and
a removing step of removing the water-insoluble layer formed on the resist pattern by removing the resist pattern with an water-based solvent to form a processed pattern.

An optical component having a processed pattern formed thereon can be obtained by using the formation of the aforementioned resist pattern containing a water-soluble polymer and removing the resist pattern by an water-based solvent in the removing step.

A method for producing an optical component having a processed pattern formed thereon according to an embodiment of the present disclosure
forms a resist pattern by curing an ink containing a water-soluble polymer in a resist pattern forming step, in which
the ink further contains a water-soluble polymer and a (meth)acrylic monomer.

With the above-described configuration, even in the case of curing the ink, when the water-soluble polymer is contained in the ink, excellent removing property is exhibited in the removing step.

According to the method for producing an optical component of an embodiment of the present disclosure, the processed pattern can be formed on the optical component by using the water-based solvent in the removing step.

### BRIEF DESCRIPTION OF DRAWINGS

Fig. 1 is a plan view of a spectacle lens;
Fig. 2 is a partial A-A' cross-sectional view of the spectacle lens;
Fig. 3 is a flowchart illustrating a method for producing the spectacle lens;
Figs. 4A to 4C are process diagrams of a resist pattern forming step;
Fig. 5 is a schematic diagram of a water-insoluble layer forming step; and
Fig. 6 is a partial cross-sectional view of the spectacle lens 1 after a removing step.

### DETAILED DESCRIPTION

The definitions of terms in the present specification will be described below.

The term "resist pattern" means a coating material having an exposed portion in a region in which a processed pattern is formed. The resist pattern is also referred to as a mask pattern.

The term "water-soluble" means a property of 1 g or more of the compound being dissolved in 100 g of water at 25°C, and the term "water-insoluble" means a property of less than 1 g of the compound being dissolved in 100 g of water at 25°C.

The term "processed pattern" means a water-insoluble layer portion remaining after the resist pattern is removed.

Hereinafter, an embodiment and an example of the present disclosure will be described. The same and corresponding portions are denoted by the same reference numerals, and redundant description will not be repeated. In the embodiment and the example described below, when the number, an amount, or the like is mentioned, the scope of the present disclosure is not necessarily limited to that number, that amount, or the like, unless otherwise specified. In the embodiment described below, each component of a configuration is not necessarily essential to the embodiment and the example of the present disclosure unless otherwise specified.

### [Configuration of Spectacle Lens 1]

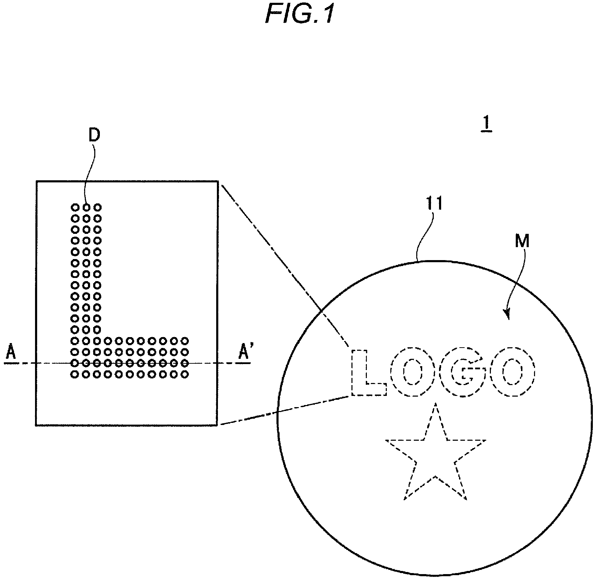

Fig. 1 is a plan view of a spectacle lens 1. The configuration of the spectacle lens 1 will be described with reference to Fig. 1. Moreover, description will be made by using, as an example, a case where a metal layer to be described later is used as a water-insoluble layer.

In the spectacle lens 1, a plurality of minute dots D are arranged isotropically and evenly and watermarks M are formed by the dots D. In this embodiment, the case of forming the watermarks M is exemplified, but the plurality of minute dots may be formed on the entire surface.

The expression "arranged isotropically and evenly" means that the dots are arranged in one direction with a constant interval. The term "constant interval" means arrangement in which a distance between the dot center of the dot and the dot center of the adjacent dot is, for example, within ±40% in terms of average value.

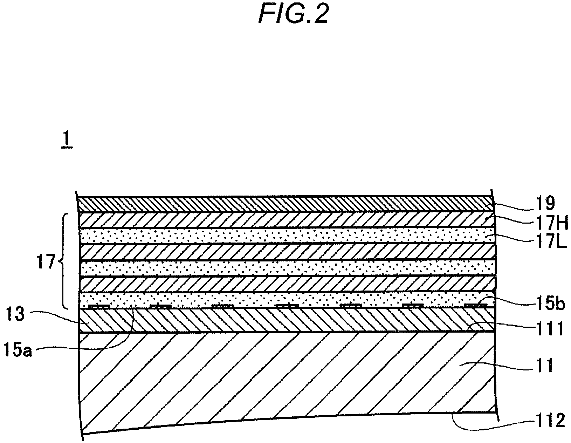

Fig. 2 is a partial A-A' cross-sectional view of the spectacle lens 1. As illustrated in Fig. 2, the spectacle lens 1 includes a spectacle lens substrate 11 (hereinafter, also simply referred to as "lens substrate"), and includes a hard coat layer 13, a metal layer 15, an antireflection layer 17, and a water-repellent layer 19 in this order on a first principal surface of the lens substrate 11.

### <Processed Pattern 15b>

In the spectacle lens 1, a processed pattern 15b containing metal is formed.

In the processed pattern 15b, apertures 15a having shapes of a plurality of minute dots are formed. The dots D of the spectacle lens 1 are formed by the apertures 15a. The apertures 15a are arranged isotropically and evenly. The apertures 15a are gathered to form a watermark such as a logo. In this way, when the apertures 15a having shapes of a plurality of minute dots are arranged isotropically with an even pitch, uncomfortable feeling on a field of view of a wearer of the spectacle lens 1 can be alleviated while a viewable watermark is formed.

Examples of the metal that is the material of the processed pattern 15b include at least one kind of metal selected from Cr, Ta, Nb, Ti, Zr, Au, Ag, and Al, and from the viewpoint of adhesive property, Cr is preferable. Incidentally, when metal is used as the material of the processed pattern 15b, an antistatic effect is also exhibited.

### <Lens Substrate 11>

Further, the lens substrate 11 will be described with reference to Fig. 2. The lens substrate 11 includes a first principal surface 111, a second principal surface 112, and a cut end surface 113.

The material of the lens substrate 11 may be either plastic or inorganic glass. Examples of the material of the substrate include a polyurethane-based material such as a polythiourethane resin or a polyurethane resin, an epithio-based material such as a polysulfide resin, a polycarbonate-based material, and a diethylene glycol bis allyl carbonate-based material.

Colorless ones are usually used as the lens substrate 11, but it is also possible to use colored ones as long as the transparency is not impaired.

The refractive index of the lens substrate 11 is, for example, 1.50 or more and 1.74 or less.

The lens substrate 11 may be either a finished lens or a semi-finished lens.

The surface shape of the lens substrate 11 is not particularly limited, and any shapes such as a flat shape, a convex shape, and a concave shape may be employed.

The spectacle lens of the present disclosure may be any of a single focus lens, a multifocal lens, a progressive power lens, and the like. Regarding the progressive power lens, usually, a near portion region (near portion) and a corridor region (intermediate region) are included in the aforementioned lower region and a distance portion region (distance portion) is included in the upper region.

### <Hard Coat Layer 13>

The hard coat layer 13 is obtained by, for example, curing a curable composition containing inorganic oxide particles and a silicon compound. The composition of the hard coat layer 13 is selected depending on the material of the lens substrate 11. Incidentally, the refractive index (nD) of the hard coat layer 13 is, for example, 1.50 or more and 1.74 or less.

### <Antireflection Layer 17>

The antireflection layer 17 has a multi-layer structure formed by alternately or continuously laminating films each having a different refractive index, and is a film to prevent light refection by interference. Examples of such an antireflection layer 17 include one which has a multi-layer structure formed by laminating a plurality of low refractive index layers 17L and high refractive index layers 17H. The refractive index of the low refractive index layer 17L is, for example, 1.35 to 1.80 in a wavelength of 500 to 550 nm. The refractive index of the high refractive index layer 17H is, for example, 1.90 to 2.60 in a wavelength of 500 to 550 nm.

The low refractive index layer 17L is formed by, for example, silica dioxide (SiO₂) which has a refractive index of about 1.43 to 1.47. In addition, the high refractive index layer 17H is formed by a material having a higher refractive index than that of the low refractive index layer 17L, and for example, such a material is composed of, at an appropriate ratio, metal oxides such as niobium oxide (Nb₂O₅), tantalum oxide (Ta₂O₅), titanium oxide (TiO₂), zirconium oxide (ZrO₂), yttrium oxide (Y₂O₃), and aluminum oxide (Al₂O₃).

### <Water-Repellent Layer 19>

The water-repellent layer 19 contains, for example, a fluorine-substituted alkyl group-containing organosilicon compound. This water-repellent layer 19 has a thickness which is set such that antireflection function is exhibited in combination with the antireflection layer 17.

### [Method for Producing Optical Component]

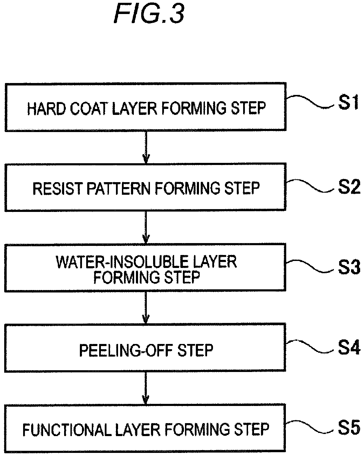

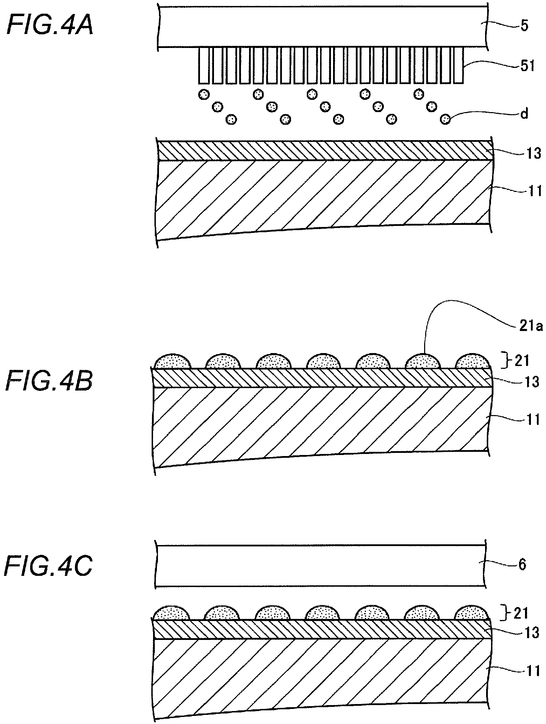

Next, a method for producing an optical component according to this embodiment will be described with reference to Fig. 3. Fig. 3 is a flowchart illustrating a method for producing the spectacle lens 1. Figs. 4 to 6 are process diagrams illustrating the method for producing the spectacle lens 1 according to the embodiment having the aforementioned configuration.

In a hard coat layer forming step (S1), the hard coat layer 13 is formed on the lens substrate 11. The hard coat layer 13 is formed, for example, by forming a film by a dipping method using a solution, which is obtained by dissolving a curable composition containing inorganic oxide particles and a silicon compound, and curing the film.

In a resist pattern forming step (S2), a resist pattern 21 containing a water-soluble polymer is formed on the spectacle lens 1. For example, the resist pattern 21 is formed using an inkjet apparatus 5 by an inkjet recording method. When the resist pattern is formed using the inkjet recording method, the process can be simplified and a minute processed pattern can be formed. The resist pattern causes a region in which the hard coat layer or the water-insoluble layer of the lens substrate is formed to be exposed. After forming the resist pattern 21, ultraviolet (UV) irradiation is performed on the resist pattern 21 to cure an ink forming the resist pattern 21. The curing time of curing by ultraviolet irradiation is shorter than that of curing by heating.

Figs. 4A to 4C are process diagrams of the resist pattern forming step (S2). As illustrated in Fig. 4A, in S2, a plurality of droplets d are discharged from inkjet nozzles 51. Subsequently, as illustrated in Fig. 4B, the discharged droplets are bonded to other droplets d on the surface of the spectacle lens 1 to form one dot portion 21a. The dot portion 21a in which the plurality of droplets d are gathered in this way is arranged to form a resist pattern. Subsequently, as illustrated in Fig. 4C, after forming the resist pattern, the resist pattern 21 is cured by subjecting the resist pattern 21 to irradiation with light such as ultraviolet (UV) by using an ultraviolet irradiation apparatus 6.

Marks such as characters and figures are formed by the aggregate of the dot portions 21a on the spectacle lens 1 formed by the resist pattern 21.

From the viewpoint of forming circular dots on the spectacle lens 1, the formation surface preferably has a high hydrophobicity, and for example, it is preferable to form the resist pattern on a surface not subjected to a hydrophilic treatment such as a plasma treatment, an ion irradiation treatment, a corona discharge treatment, or an alkali treatment.

### <Ink>

The ink used in the inkjet recording method contains, from the viewpoint of obtaining excellent removing property by the water-based solvent in a removing step (S4) to be described later and from the viewpoint of discharge stability of the ink, preferably a water-soluble polymer, and contains, from the viewpoint of obtaining excellent removing property by the water-based solvent and curability, more preferably a water-soluble polymer and a (meth)acrylic monomer.

Examples of the water-soluble polymer include polyvinylpyrrolidone, polyvinyl alcohol, and polyacrylic acid. Of these, from the viewpoint of obtaining excellent removing property by the water-based solvent, polyvinylpyrrolidone is preferable.

The weight average molecular weight of the water-soluble polymer is, from the viewpoint of obtaining excellent removing property by the water-based solvent, preferably 100 or more, more preferably 300 or more, further preferably 400 or more, further preferably 1, 000 or more, and further preferably 5, 000 or more, and is preferably 100, 000 or less. From the viewpoint of discharge stability of the ink in the inkjet recording method, the weight average molecular weight thereof is more preferably 30,000 or less and further preferably 15,000 or less.

The content of the water-soluble polymer in the ink is, from the viewpoint of obtaining excellent removing property by the water-based solvent, preferably 1% by mass or more, more preferably 2% by mass or more, and further preferably 3% by mass or more, and is preferably 30% by mass or less, more preferably 20% by mass or less, further preferably 10% by mass or less, and further preferably 8% by mass or less. From the viewpoint of obtaining excellent curability, the content thereof is further preferably 5% by mass or less and further preferably 4% by mass or less.

Examples of the (meth)acrylic monomer include monofunctional (meth)acrylate and multifunctional (meth)acrylate. Of these, from the viewpoint of curability after forming the resist pattern, a combination of monofunctional (meth)acrylate and multifunctional (meth)acrylate is preferable.

The (meth) acrylate means at least one kind selected from acrylate and methacrylate.

Examples of the monofunctional (meth)acrylate include polyethylene glycol mono(meth)acrylate and alkoxy polyethylene glycol mono(meth)acrylate.

The number of carbon atoms in the alkoxy group of alkoxy polyethylene glycol mono(meth)acrylate is preferably 1 to 4, more preferably 1 to 3, and further preferably 1 or 2.

Examples of the polyethylene glycol mono(meth)acrylate include diethylene glycol mono(meth)acrylate and triethylene glycol mono(meth)acrylate. Examples of the alkoxy polyethylene glycol mono(meth)acrylate include methoxy polyethylene glycol mono(meth)acrylate and ethoxy polyethylene glycol mono(meth)acrylate. Examples of the methoxy polyethylene glycol mono(meth)acrylate include methoxy diethylene glycol mono(mono)acrylate and methoxy triethylene glycol mono (mono) acrylate. Examples of the ethoxy polyethylene glycol mono(mono)acrylate include ethoxy diethylene glycol monoacrylate and ethoxy triethylene glycol monoacrylate.

Among these, from the viewpoint of discharge stability of the ink in the inkjet recording method, alkoxy polyethylene glycol mono(meth)acrylate is preferable, methoxy polyethylene glycol monoacrylate is more preferable, and methoxy triethylene glycol monoacrylate is further preferable.

The multifunctional (meth)acrylate is preferably difunctional (meth)acrylate. Examples of the difunctional (meth)acrylate include polyethylene glycol di(meth)acrylates. Among them, from the viewpoint of curability after forming the resist pattern and from the viewpoint of discharge stability of the ink in the inkjet recording method, polyethylene glycol diacrylate is preferable. The average addition mole number at the polyethylene glycol site of the polyethylene glycol diacrylate is preferably 3 or more, more preferably 6 or more, and further preferably 9 or more, and is preferably 30 or less, more preferably 25 or less, and further preferably 18 or less.

The content of (meth)acrylate in the ink is preferably 10% by mass or more, more preferably 20% by mass or more, and further preferably 30% by mass or more, and is preferably 70% by mass or less, more preferably 60% by mass or less, and further preferably 50% by mass or less.

The content of monofunctional (meth)acrylate in the ink is preferably 10% by mass or more, more preferably 20% by mass or more, and further preferably 30% by mass or more, and is preferably 70% by mass or less, more preferably 60% by mass or less, and further preferably 50% by mass or less.

The content of multifunctional (meth) acrylate in the ink is preferably 1% by mass or more, more preferably 3% by mass or more, and further preferably 5% by mass or more, and is preferably 30% by mass or less, more preferably 20% by mass or less, and further preferably 10% by mass or less.

The mass ratio of multifunctional (meth)acrylate/monofunctional (meth)acrylate is, from the viewpoint of curability, preferably 5/95 or more, more preferably 8/92 or more, and further preferably 10/90 or more, and is preferably 40/60 or less, more preferably 30/70 or less, and further preferably 20/80 or less.

As a photopolymerization initiator, a photopolymerization initiator having two or more hydroxyl groups is preferable.

As the photopolymerization initiator, for example, 1-[4-(2-hydroxyethoxy)-phenyl]-2-hydroxy-2-methyl-1-propane -1-one is mentioned.

The content of the photopolymerization initiator in the ink is, from the viewpoint of enhancing curability, preferably 1% by mass or more, more preferably 3% by mass or more, and further preferably 5% by mass or more, and is preferably 30% by mass or less, more preferably 20% by mass or less, and further preferably 10% by mass or less.

The content of the photopolymerization initiator is, from the viewpoint of curability, preferably 5 parts by mass or more, more preferably 8 parts by mass or more, and further preferably 10 parts by mass or more, and is preferably 40 parts by mass or less, more preferably 30 parts by mass or less, and further preferably 20 parts by mass or less with respect to the total amount 100 parts by mass of (meth)acrylate.

From the viewpoint of improving formability of the resist pattern, the ink preferably contains a high-boiling-point solvent.

The boiling point of the high-boiling-point solvent is preferably 150°C or higher, more preferably 160°C or higher, further preferably 170°C or higher, and further preferably 180°C or higher, and is preferably 350°C or lower, more preferably 330°C or lower, and further preferably 300°C or lower.

Examples of the high-boiling-point solvent include an oxyethylene or oxypropylene addition polymer such as diethylene glycol, triethylene glycol, tetraethylene glycol, or tripropylene glycol; a diol such as propylene glycol; a triol such as glycerin; thiodiglycol; a lower alkyl glycol ether such as triethylene glycol monoethyl ether or triethylene glycol monobutyl ether; and a lower dialkyl glycol ether such as triethylene glycol diethyl ether, tetraethylene glycol dimethyl ether, or tetraethylene glycol diethyl ether. They can be used either singly or in combination of two or more kinds thereof. Among them, propylene glycol is preferable.

The content of the high-boiling-point solvent in the ink is preferably 5% by mass or more, more preferably 10% by mass or more, and further preferably 15% by mass or more, and is preferably 40% by mass or less, more preferably 30% by mass or less, and further preferably 20% by mass or less.

From the viewpoint of adjusting a viscosity, the ink preferably contains water.

Examples of the water include tap water, pure water, and ion-exchange water.

The content of the water in the ink is preferably 10% by mass or more, more preferably 20% by mass or more, and further preferably 30% by mass or more, and is preferably 80% by mass or less, more preferably 70% by mass or less, and further preferably 60% by mass or less.

The viscosity of the ink is, from the viewpoint of arranging the ink by the inkjet recording method, preferably 1 mPa·s or more, more preferably 5 mPa·s or more, and further preferably 8 mPa·s or more, and is preferably 40 mPa·s or less, more preferably 30 mPa·s or less, further preferably 20 mPa·s or less, and further preferably 15 mPa·s or less.

The pH of the ink is preferably 3.0 or more, more preferably 3.5 or more, and further preferably 4.0 or more, and is preferably 12 or less, more preferably 11 or less, and further preferably 10 or less.

The contact angle of the ink with respect to a resist pattern formation surface is, from the viewpoint that the dot shape of the resist pattern is formed to be closer to a true circle, preferably 25° or more, more preferably 30° or more, and further preferably 45° or more, and is preferably 65° or less, more preferably 60° or less, further preferably 55° or less, and further preferably 53° or less. The contact angle is a value measured by a sessile drop method of JIS R 3257 : 1990. Herein, the "resist pattern formation surface" means a surface on which the resist pattern in which the ink is arranged is formed.

The inkjet recording method used herein is not particularly limited in the type and the method, but may either be a continuation type or an on-demand type; and if the inkjet recording method is an on-demand type, it may either be a piezoelectric system or a thermal system.

Examples of printing conditions include a moving speed of the lens substrate with respect to a printing head, a resolution in a moving direction, a resolution in a width direction perpendicular to the moving direction, a size of an ink droplet, a drop frequency of an ink droplet, and the number of ink droplets dropped to the same point of impact. Since these printing conditions are correlated to each other, the resist pattern 21 is formed by suitably adjusting the printing conditions.

The resist pattern 21 has the dot portions 21a corresponding to the apertures 15a to be formed on the optical component. The resist pattern 21 has a plurality of dot portions 21a arranged isotropically and evenly. The plurality of dot portions 21a are arranged, for example, in a lattice shape. The plurality of dot portions 21a may be formed on the lens substrate or the entire surface of one principal surface of the lens substrate having the hard coat layer.

An interval AD between the center of the dot portion 21a and the center of the adjacent dot portion 21a is, for example, 0.1 mm or more, preferably 0.2 mm or more, and more preferably 0.3 mm or more, and is, for example, 5.0 mm or less, preferably 3.0 mm or less, and more preferably 1.0 mm or less.

A diameter DD of the dot is, for example, 0.01 mm or more, more preferably 0.05 mm or more, and further preferably 0.1 mm or more, and is, for example, 5.0 mm or less, preferably 2.0 mm or less, more preferably 1.0 mm or less, and further preferably 0.5 mm or less.

The interval AD/the diameter DD is preferably more than 1.0, more preferably 1.1 or more, and further preferably 1.2 or more, and is preferably 2.0 or less, more preferably 1.8 or less, and further preferably 1.5 or less.

The dot density in the inkjet recording method is, from the viewpoint of improving resist pattern formability, preferably 300 dpi (dots per inch) or more, more preferably 400 dpi or more, and further preferably 500 dpi or more, and is preferably 1,000 dpi or less, more preferably 900 dpi or less, and further preferably 800 dpi or less.

The ink discharge amount per dot is, from the viewpoint of enhancing curability of the formed dots and improving resist pattern formability, preferably 600 pl (picolitre) or more, more preferably 1,000 pl or more, and further preferably 2,000 pl or more, and is preferably 600 pl or less, more preferably 5,000 pl or less, and further preferably 4,000 pl or less.

In a water-insoluble layer forming step (S3), a water-insoluble layer is formed on the spectacle lens 1 having the resist pattern 21 formed thereon.

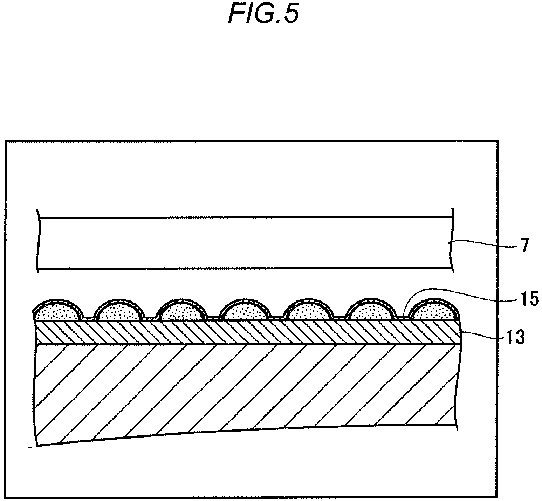

Fig. 5 is a process diagram of the water-insoluble layer forming step (S3). As illustrated in Fig. 5, for example, in S3, the metal layer 15 is deposited as the water-insoluble layer by a vapor deposition apparatus 7.

In a removing step (S4), the water-insoluble layer formed on the resist pattern is peeled off by removing the resist pattern 21 with an water-based solvent.

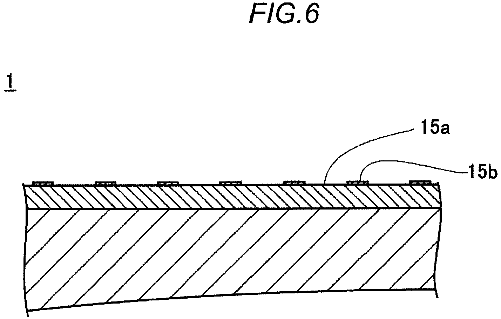

Fig. 6 is a cross-sectional view of the spectacle lens 1 after the removing step (S4). As illustrated in Fig. 6, for example, in the removing step, the resist pattern 21 containing a water-soluble polymer is removed with the water-based solvent to peel off the metal layer formed on the resist pattern 21, thereby obtaining the spectacle lens 1 including the metal layer 15 having the apertures 15a formed thereon. It is possible to prevent the surface erosion of the spectacle lens like the surface erosion caused when an organic solvent is used for removing the resist pattern, and it is possible to obtain a spectacle lens having a processed pattern formed thereon while the surface erosion thereof is suppressed when the water-based solvent is used.

The water-based solvent means a solvent containing 60% by mass or more of water. As the water-based solvent, water is preferable. Examples of a solvent, which may be contained in the water-based solvent, other than water include an alcohol-based solvent such as ethanol, methanol, or propanol, and a ketone-based solvent such as acetone or methyl ethyl ketone.

The content of the water in the water-based solvent is preferably 80% by mass or more, more preferably 90% by mass or more, further preferably 95% by mass or more, and further preferably 100% by mass.

The removing of the metal layer 15 formed on the resist pattern 21 is performed by immersing the metal layer in the water-based solvent. The temperature of the water-based solvent is preferably 15°C or higher, and more preferably 20°C or higher, and is preferably 70°C or lower, more preferably 60°C or lower, and further preferably 55°C or lower.

Ultrasonic irradiation may be performed at the time of immersion. The frequency of the ultrasonic wave is, for example, 29 kHz or more and 50 kHz or less.

The metal layer 15 on the dot portion 21a of the resist pattern is peeled off by the removing step to form the aperture 15a, which is formed at the same position as that of the dot portion 21a and has the same shape as that of the dot portion 21a, on the metal layer 15, thereby forming the processed pattern 15b.

In a functional layer forming step (S5), a functional layer is formed after the removing step. As the functional layer, for example, the antireflection layer 17 and the water-repellent layer 19 are formed. The antireflection layer 17 is formed by alternately or continuously laminating the low refractive index layer 17L and the high refractive index layer 17H. The antireflection layer 17 is formed such that each layer is formed in order from the low refractive index layer 17L at the lower layer side to have each composition and each thickness. Ion assisted deposition may be employed for the film formation.

In addition, the water-repellent layer 19 may be further formed on the outermost surface.

As described above, in the resist pattern forming step, the resist pattern 21 is formed by a specific ink. Next, in the water-insoluble layer forming step, the water-insoluble layer 15 is formed on the resist pattern 21. Subsequently, in the removing step, the resist pattern 21 is removed with an water-based solvent. According to the above steps, the metal layer 15 formed on the resist pattern 21 is peeled off to form the processed pattern 15b and the aperture 15a.

In the present disclosure, regarding the example, the content, and various physical properties of each component described above, matters exemplified in the detailed description of the invention or described as the preferred ranges may be arbitrarily combined.

Further, if compositions described in Examples are adjusted to be the compositions described in the detailed description of the invention, the embodiments of the disclosure can be carried out over the entire composition range claimed, similarly to Examples.

### Examples

Hereinafter, specific examples will be described. However, the scope of the present patent claims is not limited to the following examples.

Measurement methods and evaluation methods for various physical properties were performed by the following methods.

### [pH Measurement]

The pH of the ink was measured using a pH meter (manufactured by HORIBA, Ltd., trade name "D-51") under the condition of a temperature of 25°C by a glass electrode method.

### [Viscosity Measurement]

The viscosity of the ink was measured using a tuning fork vibration viscometer (manufactured by A&D Company, Limited, trade name "SV-10") under the condition of a temperature of 25°C according to JIS Z 8803:2011.

### [Contact Angle]

A hard coat layer formed by a hard coat liquid "HC60S" (manufactured by HOYA CORPORATION) was provided on a spectacle lens substrate produced by a monomer for a spectacle lens "MR 8" (manufactured by Mitsui Chemicals, Inc.), an ink was dropped on the lens substrate, and then the contact angle was measured by the method described in "6. Sessile Drop Method" of JIS R 3257:1990.

### Examples 1 to 6

### <Preparation of Ink>

To a sample bottle, polyethylene glycol diacrylate (average addition mole number of 14, CAS No. 26570-48-9), methoxytriethylene glycol acrylate (CAS No. 48067-72-7), and water were added thereto and stirred. Thereafter, propylene glycol was added thereto and further stirred. Further, 1% by mass of NaOH water-based solution was added thereto to adjust the pH. Thereafter, a photoinitiator "IRGACURE 2959" (manufactured by BASF) was further added thereto and stirred, 20% by mass of polyvinylpyrrolidone water-based solution (weight average molecular weight of 10,000, CAS No. 9003-39-8) was added thereto and stirred, and then the insoluble matter was removed by performing filtering, thereby obtaining Inks 1 to 6 adjusted to pH 7 presented in Table 1 . The viscosity measurement and the contact angle measurement were performed on the obtained inks. The results thereof are presented in Table 1.

### <Resist Pattern Formation>

A resist pattern having lattice dots with a dot interval of 0.432 nm and a dot diameter of 0.323 nm was formed using the obtained ink by an inkjet apparatus equipped with a nozzle "KJ4A" (manufactured by KYOCERA Corporation) at a dot density of 9600 × 600 dpi and a print width of 108 mm on a spectacle lens substrate produced by a monomer for a spectacle lens "MR 8" (manufactured by Mitsui Chemicals, Inc.) on which a hard coat layer formed by a hard coat liquid "HC60S" (manufactured by HOYA CORPORATION) is formed (the resist pattern was entirely formed on the hard coat layer at one principal surface side of the lens substrate) . Incidentally, the droplet amount per dot was set to 2400 pl. After forming the resist pattern, the resist pattern on the spectacle lens substrate was cured by irradiation at a wavelength of 365 nm and an irradiation amount of 900 mJ/cm² with a linear UV-LED "H-16LH4-V1-SM2" (manufactured by HOYA CANDEO OPTRONICS CORPORATION). It was possible to produce the resist pattern to have a circular dot without lattice defect.

### [Evaluation of UV Curability]

The state of dots on the resist pattern after curing was observed and the evaluation of UV curability was performed based on the following criteria.
A: The resist pattern is completely cured.
B: The resist pattern is cured while flexibility slightly remains.
C: The resist pattern is cured while flexibility remains.
D: The resist pattern is not cured.

After curing, a single chromium layer was deposited using argon as assist gas by ion assisted deposition.

The spectacle lens substrate on which the single chromium layer was deposited was immersed in water at 20°C for 5 minutes or immersed in water at 20°C and subjected to irradiation with ultrasonic wave for 5 minutes to thereby obtain a spectacle lens on which a processed pattern formed by the single chromium layer and having apertures was formed. The erosion on the spectacle lens surface was not observed.

### [Evaluation of Removing Property]

The evaluation of removing property was performed by a ratio (%) of the number of dots removed which configure the resist pattern.

In the table, removing property "absence of US" means the evaluation result without ultrasonic irradiation and removing property "presence of US" means the evaluation result with ultrasonic irradiation.

### Reference Example 1

Ink 51 was obtained by the same method as in Example 1, except that a polyvinylpyrrolidone water-based solution was not added and the composition was changed to the composition presented in Table 1, and the resist pattern formation, the processed pattern formation, and evaluations thereof were performed.

**[Table 1]**

| Example/Comparative Example | | | Example 1 | Example 2 | Example 3 | Example 4 | Example 5 | Example 6 | Reference Example 1 |
|---|---|---|---|---|---|---|---|---|---|
| Production Example | | | 1 | 2 | 3 | 4 | 5 | 6 | 51 |
| Ink | | | 1 | 2 | 3 | 4 | 5 | 6 | 51 |
| Blending amount (parts by mass) | Water-soluble polymer | PVP | 1 | 2 | 3.5 | 5 | 5 | 10 | 0 |
| | Acrylic monomer | PEGDA | 5 | 5 | 5 | 5 | 7.5 | 1 | 5 |
| | | MEA | 30 | 30 | 35 | 12.5 | 12.5 | 20 | 35 |
| | High-boiling-point solvent | PG | 20 | 15 | 18 | 40 | 20 | 30 | 22 |
| | Water | | 39 | 43 | 33.5 | 32.5 | 50 | 34 | 33 |
| | Photoinitiator PI-1 | | 5 | 5 | 5 | 5 | 5 | 5 | 5 |
| Physical property | Viscosity (mPa·s) | | 9.5 | 8.6 | 14.5 | 13.8 | 13.2 | 14.8 | 13.9 |
| | Contact angle (°) | | 53 | 52 | 50 | 48 | 48 | 45 | 55 |
| Evaluation | UV curability | | A | A | A | B | B | C | A |
| | Removing property (20°C-absence of US) | | 40% | 50% | 95% | 100% | 100% | 100% | 5% |
| | Removing property (20°C-presence of US) | | 95% | 95% | 100% | 100% | 100% | 100% | 80% |

Abbreviated terms in the table mean as follows.
PVP: polyvinylpyrrolidone (weight average molecular weight of 10,000, CAS No. 9003-39-8)
PEGDA: polyethylene glycol diacrylate (average addition mole number of 14, CAS No. 26570-48-9)
MEA: methoxytriethylene glycol acrylate (CAS No. 48067-72-7)
PG: propylene glycol (boiling point of 188°C)
PI-1:
   1-[4-(2-hydroxyethoxy)-phenyl]-2-hydroxy-2-methyl-1-propane -1-one (CAS No. 106797-53-9)

Finally, the embodiments of the present disclosure will be outlined by use of drawings or the like.

The method for producing an optical component having a pattern formed thereon according to an embodiment of the present disclosure includes, as illustrated in Figs. 1 to 4,
the resist pattern forming step S2 of forming the resist pattern 21 containing a water-soluble polymer on the lens substrate 11,
the water-insoluble layer forming step S3 of forming the water-insoluble layer (for example, the metal layer 15) on the lens substrate having the resist pattern 21 formed thereon, and
the removing step S4 of removing the water-insoluble layer formed on the resist pattern 21 by removing the resist pattern 21 with an water-based solvent to form the processed pattern 15b.

An optical component having the above-described pattern formed thereon can be obtained by using the aforementioned resist pattern 21 containing a water-soluble polymer and removing the resist pattern 21 with an water-based solvent in the removing step S4.

The method for producing an optical component having a pattern formed thereon according to an embodiment of the present disclosure
forms the resist pattern by curing the ink containing a water-soluble polymer in the resist pattern forming step S2, in which
the ink further contains a water-soluble polymer and a (meth)acrylic monomer.

With the above-described configuration, even in the case of curing the ink, when the water-soluble polymer is contained in the ink, excellent removing property is exhibited in the removing step.

The method for producing an optical component having a pattern formed thereon according to an embodiment of the present disclosure includes
the resist pattern forming step S2 of forming the resist pattern 21 on the lens substrate,
the water-insoluble layer forming step S3 of forming the water-insoluble layer (for example, the metal layer 15) on the lens substrate having the resist pattern 21 formed thereon, and
the removing step S4 of removing the water-insoluble layer formed on the resist pattern 21 by removing the resist pattern 21 with an water-based solvent to form the processed pattern 15b.

The method for producing an optical component having a pattern formed thereon according to an embodiment of the present disclosure
forms the resist pattern by curing the ink in the resist pattern forming step S2, in which
a contact angle of the ink with respect to the resist pattern formation surface is preferably 25° or more and 65° or less.

With the above-described configuration, the dot shape of the resist pattern can be formed to be close to a true circle.

It is to be understood that the aspects of embodiments disclosed herein are not restrictive but illustrative in all respects. The scope of the invention is defined by the appended claims rather than by the foregoing description and is intended to include the meaning equivalent to the scope of the claims and any modifications within the scope.

### [Explanation of Numerals]

1: spectacle lens
11: lens substrate
13: hard coat layer
15: metal layer
15a: apertures
15b: processed pattern
17: antireflection layer
17L: low refractive index layers
17H: high refractive index layers
19: water-repellent layer
21: resist pattern
21a: dot portion
D: dots
M: watermarks

## Claims

1. A method for producing an optical component having a processed pattern formed thereon, the method comprising:
a resist pattern forming step of forming a resist pattern containing a water-soluble polymer on a lens substrate;
a water-insoluble layer forming step of forming a water-insoluble layer on the lens substrate on which the resist pattern is formed; and
a removing step of removing the water-insoluble layer formed on the resist pattern by removing the resist pattern with an water-based solvent to form a processed pattern.

2. The method for producing an optical component according to claim 1, wherein the water-soluble polymer is polyvinylpyrrolidone.

3. The method for producing an optical component according to claims 1 or 2, wherein the water-soluble polymer has a weight average molecular weight of 100 or more and 30,000 or less.

4. The method for producing an optical component according to any one of claims 1 to 3, wherein in the resist pattern forming step, the resist pattern is formed by curing an ink containing a water-soluble polymer.

5. The method for producing an optical component according to claim 4, wherein the ink contains a water-soluble polymer and a (meth)acrylic monomer.

6. The method for producing an optical component according to claim 4 or 5, wherein the ink further contains a polymerization initiator, and
in the resist pattern forming step, light irradiation is performed after forming the resist pattern.

7. The method for producing an optical component according to any one of claims 4 to 6, wherein in the resist pattern forming step, the resist pattern is formed by an inkjet recording method.

8. The method for producing an optical component according to any one of claims 4 to 7, wherein the ink further contains a high-boiling-point solvent.

9. The method for producing an optical component according to any one of claims 4 to 8, wherein a contact angle of the ink with respect to a resist pattern formation surface is 25° or more and 65° or less.

10. The method for producing an optical component according to any one of claims 1 to 9, wherein the water-insoluble layer is a metal layer.

11. The method for producing an optical component according to any one of claims 1 to 10, wherein the water-insoluble layer forming step forms the water-insoluble layer by vapor deposition.

12. The method for producing an optical component according to any one of claims 1 to 11, wherein the resist pattern has a plurality of dot portions arranged isotropically and evenly.

13. The method for producing an optical component according to claim 12, wherein an interval between the center of the dot portion and the center of the adjacent dot portion is 0.1 mm or more and 5.0 mm or less.

14. The method for producing an optical component according to any one of claims 1 to 13, further comprising a hard coat layer forming step of forming a hard coat layer on the lens substrate before the resist pattern forming step.

15. The method for producing an optical component according to any one of claims 1 to 14, further comprising a functional layer forming step of forming a functional layer after the removing step.

16. The method for producing an optical component according to any one of claims 1 to 15, wherein the optical component is a spectacle lens.
